# EUROPEAN PATENT SPECIFICATION

(11) **EP 3 002 786 B1**
(45) Date of publication and mention of the grant of the patent: **26.05.2021**
(21) Application number: 14003420.8
(22) Date of filing: 03.10.2014
(51) Int. Cl.: H01L 23/58, H01L 21/78, H01L 23/00

(54) **Semiconductor chip**
Halbleiterchip
Puce de semi-conducteur

(43) Date of publication of application: 06.04.2016
(73) Proprietor: Sensirion AG, 8712 Stäfa (CH)
(72) Inventor: Bartsch, Ulrich, 8712 Stäfa (CH); Studer, Matthias, 8712 Stäfa (CH); Dankerl, Markus, 8712 Stäfa (CH)
(74) Representative: Sutter, Kurt

(56) References cited:
- US-A1- 2006 076 651
- US-A1- 2011 141 268
- US-A1- 2014 203 410
- US-A1- 2014 264 767

## Description

### Technical Field

The present invention relates to a semiconductor chip, in particular a sensor chip, and to a semiconductor wafer as well as to a method for manufacturing semiconductor chips.

### Background Art

Subject to the application, sensors tend to be integrated on semiconductor substrates. This kind of manufacturing is beneficial in that the size of the sensors can significantly be reduced compared to discrete type sensors, and a corresponding sensing element can be arranged together with electronic circuitry integrated on the same semiconductor substrate which circuitry may include functions acting on a signal delivered by the sensing element such as amplification, evaluation, etc.

Multiple sensor chips are manufactured from a common wafer, where the individual sensor chips are separated from the wafer e.g. by dicing the wafer. During the process of dicing, a sensing element or electronic circuitry if any may be impacted, for example, by cracks induced during the dicing process, or by contaminants infiltrated during the dicing process.

In order to avoid such damaging of the sensor chip, a seal ring may be provided around the sensing element and the electronic circuitry if any which seal ring may comprise a metal ring for protection purposes.

However, there may be cracks induced from the dicing process which may be strong enough to damage or even overcome the seal ring. Such sensor chip may be damaged without being noticed.

Similar problems arise when manufacturing other semiconductor chips, such as integrated circuits or various MEMS devices, which may not necessarily include sensor functionality.

US 2014/0203410 A1 shows die structures for electronic devices and related fabrication methods. An exemplary die structure includes a diced portion of a semiconductor substrate that includes a device region having one or more semiconductor devices fabricated thereon and an edge sealing structure within the semiconductor substrate that circumscribes the device region. In one or more embodiments, the edge sealing structure includes a conductive material that contacts a handle layer of semiconductor material, a crackstop structure is formed overlying the sealing structure, wherein the crackstop structure and the edge sealing structure provide an electrical connection between the handle layer and an active layer of semiconductor material that overlies a buried layer of dielectric material on the handle layer.

US 2014/0264767 A1 discloses a wafer that has a number of IC areas and a kerf area arranged between the IC areas. The kerf area has a dicing area, a crack stop structure arranged between an IC area and a dicing area, and a trench arranged between the crack stop structure and the dicing area. The crack stop structure includes an extended layer extending beyond the crack stop structure towards the dicing area.

US 211141268 A1 discloses the preamble of claim 1 of the present application and provides a semiconductor device having a structure, which is adopted for highly precise visual inspection with a lower cost. A semiconductor device is a semiconductor device having a region for forming an electric circuit, and includes seal rings provided in an interconnect layer and surrounding the region for forming an electric circuit, and a dummy metal via provided in the interconnect layer and located outside of the seal rings. In a cross section perpendicular to an elongating direction of the seal ring, the width of the dummy metal via is smaller than the width of the seal ring.

### Disclosure of the Invention

Hence, it is desired to provide a mechanism for proving the integrity of the seal ring of a semiconductor chip.

This problem is solved by a semiconductor chip according to the features of the independent claim 1.

The semiconductor chip comprises a substrate, preferably a semiconductor substrate, and in particular a silicon substrate. A stack of insulating layers is arranged at one side of the substrate. A sensing element can be arranged either on the stack, can be integrated into the stack, or can be arranged on the substrate, and a circuit formed by conducting elements is provided in the stack for electrically connecting the sensing element. Alternatively to such a sensing element, or in addition thereto, electronic circuitry may be integrated in the semiconductor chip. Such electronic circuitry may encompass a pre-processing of a signal of a sensing element, such as an amplification, an evaluation, a conversion of the sensor signal, but the electronic circuitry may also have any other function. Preferably, the stack of layers is a stack of CMOS layers defined for applying CMOS manufacturing processes. Specifically, some of the conducting elements in the stack may represent electrodes or heaters for interacting with the sensing element. For generating the circuit, the stack may contain various metal layers, preferably in line with a CMOS manufacturing convention, one or more of which metal layers may be prepared for interaction with the sensing element.

In the present context, the semiconductor chip area in which the sensing element, if any, and its circuit, and/or the electronic circuitry, if any, resides is referred to as centre area, although it is noted that this area may not coincide with the centre of gravity of the semiconductor chip. It is referred to as centre area for the reason that it is surrounded by an area referred to as seal ring. Hence, the centre area shall refer to an area in the planar extension of the semiconductor chip that deserves protection and therefore is confined by the seal ring. Typically, the centre area will consume nearly the entire chip area except for boundary areas as will be explained later on.

Between the centre area and an edge of the semiconductor chip, the seal ring is arranged, as well as an optical inspection area. Both, the seal ring and the optical inspection area, comprise conductive structures around the centre area, preferably encircling the sensing element and its circuit or the electronic circuitry, respectively. The seal ring serves for protecting the centre area from lateral impact, in particular during dicing. As mentioned above, the centre area with stress sensitive components such as the sensing element and/or electronic circuitry, may by impacted during dicing: Cracks may occur during dicing and propagate through the stack towards the sensing element and/or the electronic circuitry. The same holds true for chippings induced by dicing and any other effects potentially mechanically or chemically impacting the centre area, such as the infiltration of contaminants, like humidity, shall be subsumed under the term "crack". The seal ring preferably comprises a conductive structure, preferably in form of a ring. Preferably, the ring structure represents a vertical wall within the stack around the centre area. In a preferred embodiment, the seal ring is built from multiple rings in different levels of the stack, between adjacent insulating layers. The rings are preferably made from metal layers of the stack in line with CMOS processing. Preferably, the rings of adjacent levels are connected by interconnect elements, which interconnect elements may be manufactured as metal films in the insulating layers. The interconnect elements may in each of their levels also be formed as rings. Generally, the term ring is understood as a closed loop, e.g. in form of a circle / annulus or a polygon.

The optical inspection area is configured to enable the detection of a crack propagated into the optical inspection area from the outside, e.g. during the dicing process. Hence, the optical inspection area is provided for proving the integrity of the seal ring. In case, the optical inspection area shows no crack, the seal ring can be assumed to be free of cracks, which in turn may lead to the assumption that the centre area is free of cracks, too. On the other hand, in case the optical inspection area shows a crack, the crack may also propagate into the seal ring and at worst into the centre area where it may affect the functionality of the semiconductor chip. Hence, the optical inspection area allows for a statement as to the integrity of the seal ring and finally the impairment of the function of the semiconductor chip. The optical inspection area comprises a conductive structure arranged in the stack. This conductive structure is electrically disconnected from the conducting structure of the seal ring. In one embodiment, the optical inspection area contains an electrically conducting ring structure identical or similar to the ring structure of the seal ring. Hence, in this embodiment, the optical inspection area may also include multiple rings each of which rings is arranged on a different level in the stack. The rings of adjacent levels are electrically connected by one or more interconnect elements. It is desired to make cracks induced into the stack propagate vertically through the rings of the optical inspection area up to a top ring which is accessible for optical inspection. In case a crack can be inspected in the top ring, it can be assumed that the crack is strong enough to even propagate into the seal ring given that the crack has made it to the top ring of the optical inspection area while possibly entering the optical inspection area at a lower level.

It is preferred that the optical inspection is conducted in an automated manner - which embodiment is independent from the present design of the optical inspection area - and preferably by taking an image of the top of the optical inspection area with an inspection camera. In such image, a crack in the top ring may be visible in form of a colour different to the colour of the ring. In more general terms, the image taken from at least the optical inspection area is compared to a reference image. If this comparison indicates the presence of a crack, the subject semiconductor chip can e.g. be discarded as potentially defective.

In a different embodiment, only a single metal ring is provided in the optical inspection area, preferably at its top. In this scenario, a crack entering the optical inspection area at a lower level may also vertically propagate to the top metal ring through the stack of insulating layers even without the provision of further lower level rings. Again, such a crack can be detected by comparing the image taken from at least the optical inspection area with a reference image.

The image taken from the semiconductor chip, as well as the reference image it is compared to, may include not only the optical inspection area but e.g. also the seal ring in order to increase chances for detecting cracks and other defects.

A crack stop area is provided between the optical inspection area and the edge of the semiconductor chip. In a wafer arrangement, as will be described in more detail later on, the crack stop area resides next to a dicing area along which dicing area the wafer is diced into individual semiconductor chips by means of a dicing tool.

The crack stop area is implemented in the stack and serves for preventing an expansion of a crack induced from dicing a semiconductor wafer into multiple semiconductor chips. For this purpose, the crack stop area in one embodiment comprises a conductive structure, which conductive structure is disconnected from the conductive structure in the optical inspection area. The crack stop area may not only prevent an expansion of the cracks towards the optical inspection area. It may also be considered as a predetermined breaking point where chippings break off from the semiconductor chip, thereby preventing the chippings from reaching further into the semiconductor chip.

The conductive structure in the crack stop area comprises individual conductive elements arranged on different levels in the stack. These conductive elements are disconnected from each other per level and across levels. The conductive elements of at least two vertically adjacent levels are offset from each other in a direction from the centre area to the edge. In a top view the crack stop area would be entirely covered by the conductive elements arranged in the various levels. It was found that such arrangement is especially suited for stopping the propagation of chipping effects, i.e. chippings that break off from the edge of the semiconductor chip do not reach further than the crack stop area.

In an alternative example of a crack stop area not falling within the scope of the present invention, multiple concentric rings are arranged in the stack around the centre area. Preferably, the height of each ring is more than the height of an insulating layer. It was found that such walls are suited to serve as multi-stage propagation inhibitor for cracks including chippings, since the cascade of subsequent walls stops their expansion. Preferably, each ring shaped wall is built from individual rings on the various levels in the stack, and preferably formed from rings made from at least some of the metal layers in the stack, while interconnect elements in the insulating layers may show the form of rings either for completing the vertical wall of a ring.

In a preferred embodiment, the semiconductor chip is a sensor chip, and in particular it is used as a gas flow sensor or a liquid flow sensor. However, the sensor chip may serve for measuring any other measure and as such may be embodied as one of a humidity sensor, a gas sensor for a gas other than humidity, a pressure sensor, an infrared sensor. Corresponding sensing elements are provided.

Preferably, multiple semiconductor chips are manufactured from a common wafer. Hence, a semiconductor wafer to manufacture multiple semiconductor chips from comprises a wafer substrate, a stack of insulating layers arranged on the wafer substrate, and multiple sensing elements or electronic circuitry units, each sensing element or circuitry unit being arranged in an area of the wafer that later on will be referred to as centre area of the corresponding semiconductor chip. At this stage, the electronic circuitry may also be integrated in the corresponding centre area as is circuitry, e.g. for connecting an associated sensing element. At this stage, each future semiconductor chip may show its seal ring structure, its optical inspection area and its crack stop structure, including the corresponding conductive structures. Hence, between each two adjacent centre areas of two semiconductor chips of the semiconductor wafer, the following sequence of areas is provided: A seal ring of the first semiconductor chip, an optical inspection area of the first semiconductor chip, a crack stop area of the first semiconductor chip, a dicing area for separating the two semiconductor chips from each other, another crack stop area of the second semiconductor chip, another optical inspection area of the second semiconductor chip, and another seal ring of the second semiconductor chip.

According to another aspect of the present invention, a method is provided for manufacturing semiconductor chips from a semiconductor wafer according to claim 10. The wafer is diced along the various dicing areas into individual semiconductor chips. At least the optical inspection area of each semiconductor chip is inspected for the appearance of cracks after dicing. The inspection may be performed in an automated manner. Preferably, the optical inspection is embedded into an optical inspection where an image of the entire semiconductor chip is taken by a camera including the optical inspection area. The image taken is compared to a reference image. In case of a deviation of the image taken from the reference image indicating the appearance of a crack in the optical inspection area, the semiconductor chip is separated from semiconductor chips showing no crack in the optical inspection area, and as a result may be sorted out. Defects in other areas of the semiconductor chips, e.g. in the centre area, that may be identified in the automated optical inspection, may also lead to separating the semiconductor chip.

Advantageous embodiments of the present idea are listed in the dependent claims as well as in the description below. All the described embodiments shall similarly pertain to the semiconductor chip, the wafer, and to the method for manufacturing a semiconductor chip. Synergetic effects may arise from different combinations of the embodiments although they might not be described in detail.

### Brief Description of the Drawings

The embodiments defined above and further embodiments, features and advantages of the present invention can also be derived from the examples of embodiments to be described hereinafter in connection with the drawings in which the figures illustrate:
FIG. 1 a cross section of a sensor chip according to a first embodiment of the present invention,
FIG. 2 a cross section of a part of a semiconductor wafer according to an embodiment of the present invention,
FIG. 3 a top view on a part of semiconductor wafer according to an embodiment of the present invention,
FIG. 4 a cross-section of a part of a sensor chip which is not in accordance with the present invention, and
FIG. 5 a cross-section of a part of a sensor chip according to another embodiment of the present invention.

### Modes for Carrying Out the Invention

Identical elements are referred to by the same reference numerals in all Figures.

In the following, the invention is described in the context of a sensor chip. However, and as mentioned, it can also be used for other types of semiconductor chips, such as (general) integrated circuits and MEMS devices, with or without sensing functionality.

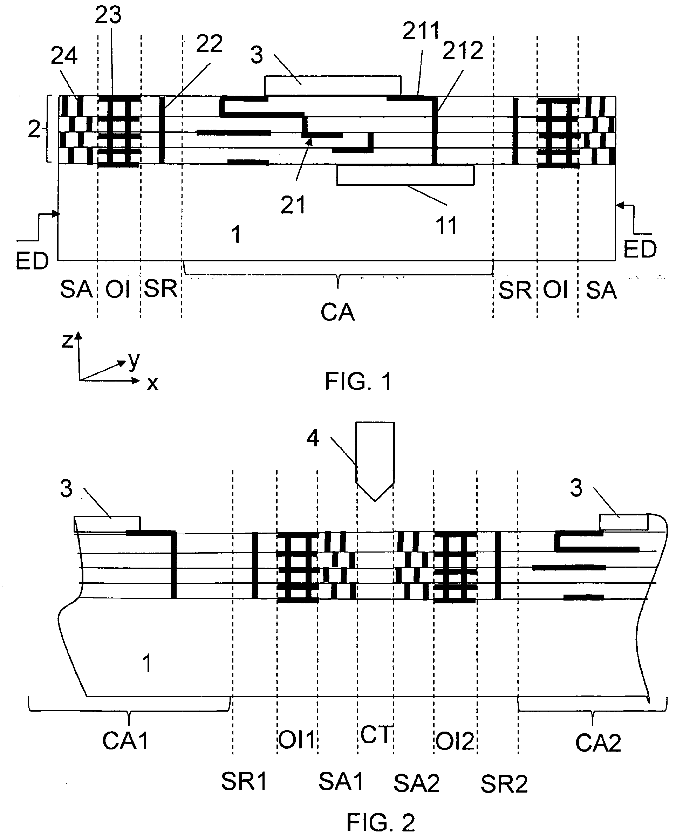

According to Figure 1, a sensor chip according to an embodiment of the present invention is shown in a cross section. The sensor chip comprises a substrate 1 such as a silicon substrate. A stack of dielectric and metal layers is arranged on the substrate 1 and is collectively referred to by 2. The dielectric layers of this stack 2 may contain SiO or SiN, the metal layers may contain Al. A sensing element 3 is arranged on top of the stack, in this example, however, it may also be embedded in the stack 2, or arranged on the substrate 1. In addition, electronic circuitry 11 is integrated into the stack 2 of the sensor chip. The layers of the stack 2 are preferably CMOS layers and may inter alia be used for contacting the sensing element 3 and the electronic circuitry 11. For this purpose, a circuit 21 is provided comprising horizontal conducting elements 211 fabricated from the metal layers, and interconnects 212 in form of vias. One of or more of the metal layers may also be used for building contact pads for contacting the sensor chip from the outside.

The sensor chip has a plane extension in x/y direction and comprises a centre area CA in this plane. In this centre area CA, the sensing element 3, the electronic circuitry 11 and the circuit 21 are arranged. Outside the centre area CA, and specifically between the centre area CA and an edge ED of the sensor chip, a seal ring SR is arranged in the stack 2 which seal ring SR comprises a vertical conducting structure 22 in form of a ring. Next towards the edge ED of the sensor chip, an automated optical inspection area OI is provided, which optical inspection area OI comprises another conductive structure 23 in form of a ring which is disconnected from the conductive structure 22 of the seal ring SR. Between the optical inspection area 01 and the edge ED of the sensor chip a crack stop area SA is provided containing a conductive structure 24 in form of multiple individual conducting elements disconnected from each other within a common level and vertically across levels. The conducting elements are also disconnected from the conductive structure 23 of the optical inspection area OI. The sensor chip was diced along its edge/s for separation from a semiconductor wafer. The conductive structure 24 in the crack stop area SA serves for stopping or limiting a propagation of cracks further towards the centre area. The crack stop area SA can also be considered as a defined breaking point for where chippings break off. While some cracks may still overcome the crack stop area SA and propagate into the optical inspection area OI, the conductive structure 23 is prepared to propagate at least strong cracks or other defects entering the optical inspection area OI from the crack stop area SA up to its top ring, where cracks become visible to optical inspection tools such as cameras or microscopes. In case such crack can be identified in the optical inspection area OI, it may in one embodiment be assumed that such crack may also have entered the seal ring SR and possibly has broken the seal ring such the seal ring no longer is considered of integrity. As a result, the sensor chip may not be allowed to be used given that the crack may even have reached and possibly impacted the structures in the centre area.

FIG. 2 illustrates a cross section of a part of a semiconductor wafer according to an embodiment of the present invention, with two sensor chips according to Figure 1 residing next to each other in the semiconductor wafer prior to dicing. Hence, instead of the individual substrates 1, a common wafer 1 is provided. In between the crack stop areas SA1 and SA2 of the respective sensor chips, a dicing area CT is visible, and a schematic dicing tool 4 which serves for separating the sensor chips from each other by dicing along the dicing area CT.

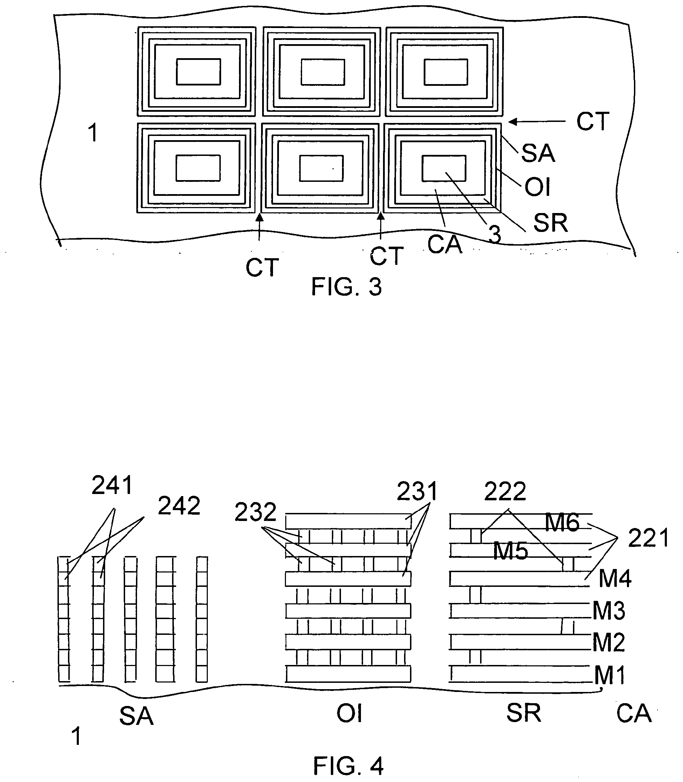

FIG. 3 illustrates a top view on a portion of semiconductor wafer according to an embodiment of the present invention, comprising six sensor chip structures manufactured on a common wafer substrate 1. It becomes apparent, that for each sensor chip, the seal ring SR, the optical inspection area OI and the crack stop area SA extend around the centre area CA of the sensor chip. The dicing areas for dicing the wafer into the individual sensor chips are referred to by CT.

FIG. 4 illustrates a cross-section of a part of a sensor chip which is not in accordance with the present invention. The illustrated part may be considered as left hand part of the sensor chip of Figure 1, such that the centre area extends to the right hand side and is not further shown. (It must be noted, though, that FIG. 4 shows a different design of the metallic structures in the seal ring SR and the crack stop area SA.) Further, it is only the stack 2 that is schematically shown in FIG. 4, and not the substrate 1 underneath the stack 2. In this sensor chip, it is envisaged that metal layers M1 to M6 of a CMOS process are provided and insulating layers in between the metal layers M1 to M6. Presently, the seal ring SR comprises structures in each metal layer M1 - M6 forming rings 221 that are not connected to any conducting element in the optical inspection area OI, nor in the centre area CA. The rings 221 are connected by interconnect elements 222 formed in the insulating layers of the stack 2. The interconnect elements 222 preferably are rings themselves, however, of a smaller width than the rings 221.

The optical inspection area OI is separated from the seal ring SR by an area free of conducting elements. The optical inspection area OI comprises a seal ring like structure, again containing rings 231 formed in each metal layer M1 - M6 of the stack 2. The rings 231 are again connected by interconnect elements 232 in the insulating layers, wherein preferably each insulating layer comprises multiple interconnect elements 232 in from of concentric rings. In a different example, the interconnect elements 232 may be non-ring structures such as posts, bars, etc.

The outer crack stop area SA comprises multiple concentric rings around the optical inspection area OI extending vertically in the stack 2, however at selected heights. Specifically, multiple rings 241 of different radii are built from the same metal layer Mx. In the insulating layers corresponding concentric rings 242 having the same radii are manufactured. Concentric vertical rings do result from this manufacturing.

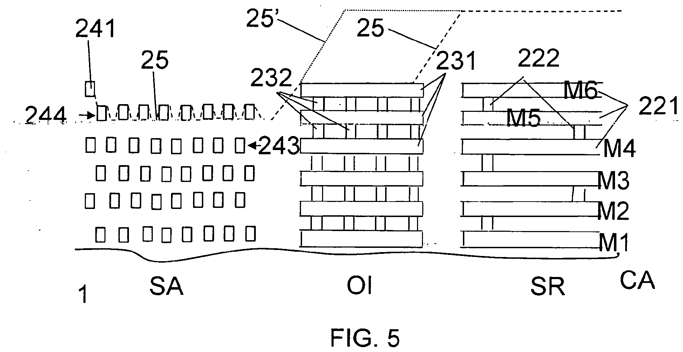

FIG. 5 illustrates a cross-section of a part of a sensor chip according to another embodiment of the present invention, where only the pattern of conducting structure in the crack stop area SA differs from the arrangement of Figure 4. Here, individual conducting elements 243, 244 in form of posts are manufactured in the metal layers M1 - M6 without having interconnect elements to other conducting elements. The conducting elements 243 are offset from the conducting elements 244.

FIG. 5 also shows the top surface of a passivation layer 25, by means of a dashed line. This passivation layer is a dielectric layer, e.g. of Si02 and/or SiN, applied to the top of the semiconductor chip. It extends over at least part of the center area CA and protects the structures below it, in particular the metal layers of stack 2. Typically, the passivation layer 25 covers most of central area CA, with the possible exception of metal areas that need to be exposed, such as contact pads for bond wires or electrodes for contacting sensing element 3. In most embodiments, passivation layer 25 covers at least 80% of central area CA.

Advantageously and as shown, the passivation layer 25 does not extend over the crack stop area SA (e.g. by being etched off in this area). This prevents cracks and chippings from extending through the passivation layer in this area. Further, the passivation layer 25 does advantageously also not extend over the optical inspection area OI in order to render this area more accessible to optical inspection. However, and as shown by means of a dotted line 25', the optical inspection area 01 may also be covered by the passivation layer because typical passivation layers are sufficiently transparent to allow an optical inspection of the layers below them.

This type of passivation layer 25 is also advantageously applied to the embodiments of Figures 1 and 4, albeit not shown in these figures.

As shown in the embodiment of Figure 5, in the top metal layer a single ring 241 is provided, or a ring like structure formed by multiple individual conducting elements 243. Such topography is used for defining a breaking point for the passivation layer 25: Hence, in the crack stop area SA, the passivation layer will follow the recess defined by the different heights of the conducting structures such that the passivation layer is weakened in the crack stop area SA and may break there upon dicing.

## Claims

1. Semiconductor chip, comprising
a substrate (1),
a stack (2) of insulating layers arranged on the substrate (1),
in a centre area (CA) of the semiconductor chip at least one of
- a sensing element (3), and a circuit (21) in the stack (2) for electrically connecting the sensing element (3), and
- electronic circuitry (11) in the stack (2),
between the centre area (CA) and an edge (ED) of the semiconductor chip:
- a seal ring (SR), and
- an optical inspection area (OI),
wherein both, the seal ring (SR) and the optical inspection area (OI), comprise conductive structures (22, 23) around the centre area (CA),
wherein the optical inspection area (OI) is arranged between the seal ring (SR) and the edge (ED) of the semiconductor chip,
wherein each of the seal ring (SR) and the optical inspection area (OI) is implemented in the stack (2),
wherein the seal ring (SR) is configured to protect the centre area (CA) from lateral impact, and
wherein the optical inspection area (OI) is configured to enable the detection of a crack propagated into the optical inspection area (OI) by optical inspection means,
**characterized in that**
the semiconductor chip further comprises a crack stop area (SA) between the optical inspection area (OI) and the edge (ED) of the semiconductor chip,
wherein the crack stop area (SA) is implemented in the stack (2), and
wherein the crack stop area (SA) is configured to prevent an expansion of a crack towards the centre area (CA) induced from dicing a semiconductor wafer into multiple semiconductor chips,
wherein the crack stop area (SA) comprises a conductive structure (24) for preventing the expansion of cracks,
wherein the conductive structure (24) in the crack stop area (SA) is disconnected from the conducting structure (23) in the optical inspection area (OI),
wherein the conductive structure (24) of the crack stop area (SA) includes multiple conductive elements (243, 244) on different levels in the stack (2) disconnected from each other per level and across levels,
and wherein the conductive elements (243, 244) of at least two adjacent levels are offset from each other in a direction from the centre area (CA) to the edge (ED).

2. Semiconductor chip according to claim 1,
wherein the conductive structure (22) of the seal ring (SR) is electrically disconnected from the circuit (21) in the centre area (CA).

3. Semiconductor chip according to claim 2,
wherein the conductive structure (22) of the seal ring (SR) includes multiple rings (221), each of which rings (221) is arranged on a different level in the stack (2), and
wherein the rings (221) of adjacent levels are electrically connected by interconnect elements (222) .

4. Semiconductor chip according to any one of the preceding claims,
wherein the conductive structure (23) of the optical inspection area (01) is electrically disconnected from the conductive structure (22) of the seal ring (SR).

5. Semiconductor chip according to claim 4,
wherein the conductive structure (23) in the optical inspection area (OI) includes multiple rings (231), with each of said rings (231) being arranged on a different level in the stack (2), and
wherein the rings (231) of adjacent levels are electrically connected by interconnect elements (232) .

6. Semiconductor chip according to claim 4,
wherein the conductive structure (23) in the optical inspection area (OI) comprises a single ring arranged in the stack (2).

7. Semiconductor chip according to any of the preceding claims further comprising a passivation layer (25) applied to a top of the semiconductor chip and extending over at least part said center area (CA),
wherein said passivation layer (25) does not extend over said crack stop area (SA),
and wherein said passivation layer (25) does not extend over said optical inspection area (01).

8. Semiconductor chip according to any one of the preceding claims 3, 5, 6,
wherein the stack (2) comprises metal layers on various levels in between corresponding insulating layers of the stack (2), from which one or more metal layers the circuit (21) in the centre area (CA), the conductive structure (22) of the seal ring (SR), the conductive structure (23) of the optical inspection area (OI) and the conductive structure (24) of the crack stop area (SA) are made.

9. Semiconductor wafer to manufacture multiple semiconductor chips from, comprising
a wafer substrate (1),
a stack (2) of insulating layers arranged on the wafer substrate (1),
for each semiconductor chip of the wafer (1) a centre area (CA) with at least one of
- a sensing element (3), and a circuit (21) in the stack (2) connecting the sensing element (3), and
- electronic circuitry (11) in the stack (2), and
between each two adjacent centre areas (CA) an arrangement of:
- a seal ring (SR1);
- an optical inspection area (OI1);
- a crack stop area (SA1),
- a dicing area (CT),
- another crack stop area (SA2),
- another optical inspection area (012), and
- another seal ring (SR2),
wherein both, the seal ring (SR1) and the optical inspection area (OI1), comprise conductive structures around the corresponding first of the two adjacent centre areas (CA), and
wherein both, the other seal ring (SR2) and the other optical inspection area (012), comprise conductive structures around the corresponding second of the two adjacent centre areas (CA),
wherein for each semiconductor chip of the wafer (1)
- the optical inspection area (OI1, 012) is arranged between the seal ring (SR1, SR2) and the dicing area (CT),
- each of the seal ring (SR1, SR2) and the optical inspection area (OI1, 012) is implemented in the stack (2),
- the seal ring (SR1, SR2) is configured to protect the centre area (CA) from lateral impact, and
- the optical inspection area (OI1, OI2) is configured to enable the detection of a crack propagated into the optical inspection area (OI1, 012) by optical inspection means,
wherein the crack stop area (SA) and the other crack stop area (SA2) are implemented in the stack (2), and
wherein the crack stop area (SA) and the other crack stop area (SA2) are configured to prevent an expansion of a crack towards the centre area (CA) induced from dicing a semiconductor wafer into multiple semiconductor chips,
wherein the crack stop area (SA) and the other crack stop area (SA2) comprise a conductive structure (24) for preventing the expansion of cracks,
wherein the conductive structures (24) in the crack stop area (SA) and in the other crack stop area (SA2) are disconnected from the conducting structure (23) in the optical inspection area (01),
wherein the conductive structures (24) of the crack stop area (SA) and the other crack stop area (SA2) include multiple conductive elements (243, 244) on different levels in the stack (2) disconnected from each other per level and across levels,
and wherein the conductive elements (243, 244) of at least two adjacent levels are offset from each other in a direction from the centre area (CA) to the edge (ED).

10. Method for manufacturing semiconductor chips from a semiconductor wafer according to claim 9, comprising the steps of
dicing the wafer (1) along the dicing area (CT) into individual semiconductor chips,
optically inspecting at least the optical inspection area (OI) of each semiconductor chip for the appearance of cracks, and
in case of an appearance of a crack separating the subject semiconductor chip.

11. Method according to claim 10,
wherein the optical inspection step includes
- taking an image of at least the optical inspection area (OI), in particular taking an image of at least the optical inspection area (OI) and the seal ring (SR),
- comparing the image taken with a reference image, and
- separating the subject semiconductor chip in case of a deviation of the image taken from the reference image indicating the appearance of a crack.

## Patentansprüche

1. Halbleiterchip, umfassend
ein Substrat (1),
einen Stapel (2) aus isolierenden Schichten, die auf dem Substrat (1) angeordnet sind,
in einem zentralen Bereich (CA) des Halbleiterchips, mindestens eines von
- ein Sensorelement (3) und einer Schaltung (21) im Stapel (2) zum elektrischen Verbinden des Sensorelements (3), und
- elektronische Schaltungen (11) im Stapel (2),
zwischen dem zentralen Bereich (CA) und einem Rand (ED) des Halbleiterchips :
- einen Dichtungsring (SR), und
- einen optischen Inspektionsbereich (OI),
wobei sowohl der Dichtungsring (SR) als auch der optische Inspektionsbereich (OI) leitende Strukturen (22, 23) um den zentralen Bereich (CA) herum aufweisen,
wobei der optische Inspektionsbereich (RO) zwischen dem Dichtungsring (SR) und dem Rand (ED) des Halbleiterchips angeordnet ist,
wobei jedes der beiden Elemente, der Dichtungsring (SR) und der optische Inspektionsbereich (OI), im Stapel (2) vorgesehen ist,
wobei der Dichtungsring (SR) so konfiguriert ist, dass er den mittleren Bereich (CA) vor seitlichen Stössen schützt, und
wobei der optische Inspektionsbereich (RO) so konfiguriert ist, dass er die Erkennung eines sich im optischen Inspektionsbereich (RO) ausbreitenden Risses durch optische Inspektionsmittel ermöglicht,
**dadurch gekennzeichnet, dass** der Halbleiterchip weiter einen Rissstoppbereich (SA) zwischen dem optischen Inspektionsbereich (RO) und dem Rand (ED) des Halbleiterchips umfasst,
wobei die Rissstoppbereich (SA) im Stapel (2) vorgesehen ist, und
wobei der Rissstoppbereich (SA) so konfiguriert ist, dass er die Ausdehnung eines Risses in Richtung des zentralen Bereichs (CA) verhindert, die durch das Schneiden eines Halbleiterwafers in eine Vielzahl von Halbleiterchips induziert wird,
wobei der Rissstoppbereich (SA) eine leitende Struktur (24) umfasst, um eine Rissausdehnung zu verhindern,
wobei die leitende Struktur (24) im Rissstoppbereich (SA) von der leitenden Struktur (23) im optischen Inspektionsbereich (RO) getrennt ist,
wobei die leitende Struktur (24) des Rissstoppbereichs (SA) mehrere leitende Elemente (243, 244) auf verschiedenen Ebenen des Stapels (2) umfasst, die auf einer Ebene und über die Ebenen hinweg voneinander getrennt sind,
und die leitenden Elemente (243, 244) von mindestens zwei benachbarten Ebenen in einer Richtung vom zentralen Bereich (CA) zum Rand (ED) gegeneinander versetzt sind.

2. Halbleiterchip nach Anspruch 1,
wobei die leitende Struktur (22) des Dichtungsrings (SR) von der Schaltung (21) im zentralen Bereich (CA) elektrisch getrennt ist.

3. Halbleiterchip nach Anspruch 2,
wobei die leitende Struktur (22) des Dichtungsrings (SR) eine Vielzahl von Ringen (221) umfasst, wobei jeder der Ringe (221) auf einer anderen Ebene im Stapel (2) angeordnet ist, und
wobei die Ringe (221) benachbarter Ebenen durch Zwischenschaltelemente (222) elektrisch verbunden sind.

4. Halbleiterchip nach einem der vorangehenden Ansprüche,
wobei die leitende Struktur (23) des optischen Inspektionsbereichs (RO) elektrisch von der leitenden Struktur (22) des Dichtungsrings (SR) getrennt ist.

5. Halbleiterchip nach Anspruch 4,
wobei die leitende Struktur (23) im optischen Inspektionsbereich (OI) eine Vielzahl von Ringen (231) umfasst, wobei jeder der Ringe (231) auf einer anderen Ebene im Stapel (2) angeordnet ist, und
wobei die Ringe (231) benachbarter Ebenen durch Zwischenschaltelemente (232) elektrisch verbunden sind.

6. Halbleiterchip nach Anspruch 4,
wobei die leitende Struktur (23) des optischen Inspektionsbereichs (RO) einen einzelnen, im Stapel (2) angeordneten Ring umfasst.

7. Halbleiterchip nach einem der vorangehenden Ansprüche, weiter umfassend eine Passivierungsschicht (25), die auf der Oberseite des Halbleiterchips aufgebracht ist und sich über mindestens einen Teil des zentralen Bereichs (CA) erstreckt,
wobei sich die Passivierungsschicht (25) nicht über den Rissstoppbereich (SA) erstreckt, und
wobei sich die Passivierungsschicht (25) vorzugsweise nicht über den optischen Inspektionsbereich (OI) erstreckt.

8. Halbleiterchip nach einem der vorangehenden Ansprüche 3, 5, 6,
wobei der Stapel (2) Metallschichten auf verschiedenen Ebenen zwischen entsprechenden Isolierschichten des Stapels (2) aufweist, von denen die Schaltung (21) im zentralen Bereich (CA), die leitende Struktur (22) des Dichtungsrings (SR), die leitende Struktur (23) des optischen Inspektionsbereichs (RO) und die leitende Struktur (24) des Rissstoppbereichs (SA) aus einer oder mehreren Metallschichten hergestellt sind.

9. Halbleiterwafer zur Herstellung mehrerer Halbleiterchips, umfassend
ein Wafersubstrat (1),
ein Stapel (2) aus isolierenden Schichten, die auf dem Substrat des Wafers (1) angeordnet sind,
für jeden Halbleiterchip des Wafers (1), einen zentralen Bereich (CA) mit mindestens einem der folgenden Elemente
- ein Sensorelement (3) und eine Schaltung (21) im Stapel (2), die das Sensorelement (3) verbindet, und
- elektronische Schaltungen (11) im Stapel (2), und
zwischen jeweils zwei benachbarten zentralen Bereichen (CA) eine Anordnung mit:
- einem Dichtungsring (SR1),
- einem optischen Inspektionsbereich (OI1),
- einem Rissstoppbereich (SA1),
- einem Schneidbereich (CT),
- einem weiteren Rissstoppbereich (SA2),
- einem weiteren optischen Inspektionsbereich (OI2), und
- einem weiteren Dichtungsring (SR2),
wobei sowohl der Dichtungsring (SR1) als auch der optische Inspektionsbereich (OI1) leitende Strukturen um den ersten entsprechenden der beiden benachbarten zentralen Bereiche (CA) aufweisen, und
wobei sowohl der weitere Dichtungsring (SR2) als auch der weitere optische Inspektionsbereich (OI2) leitende Strukturen um den entsprechenden zweiten der beiden benachbarten zentralen Bereiche (CA) aufweisen,
wobei für jeden Halbleiterchip des Wafers (1)
- der optische Inspektionsbereich (OI1, OI2) zwischen dem Dichtring (SR1, SR2) und dem Schneidbereich (CT) angeordnet ist,
- jeder der Dichtungsringe (SR1, SR2) und der optische Inspektionsbereich (OI1, OI2) im Stapel (2) vorgesehen ist,
- der Dichtungsring (SR1, SR2) so konfiguriert ist, dass er den zentralen Bereich (CA) vor seitlichen Stössen schützt, und
- der optische Inspektionsbereich (OI1, OI2) so konfiguriert ist, dass er die Erkennung eines sich im optischen Inspektionsbereich (OI1, OI2) ausbreitenden Risses durch optische Inspektionsmittel ermöglicht, wobei der Rissstoppbereich (SA) und der weitere Rissstoppbereich (SA2) im Stapel (2) vorgesehen sind, und
wobei der Rissstoppbereich (SA) und der weitere Rissstoppbereich (SA2) so konfiguriert sind, dass sie die Ausdehnung eines Risses in Richtung des zentralen Bereichs (CA) verhindern, der durch das Schneiden eines Halbleiterwafers in eine Vielzahl von Halbleiterchips induziert wird,
wobei der Rissstoppbereich (SA) und der weitere Rissstoppbereich (SA2) eine leitende Struktur (24) aufweisen, um eine Rissausdehnung zu verhindern,
wobei die leitenden Strukturen (24) im Rissstoppbereich (SA) und im weiteren Rissstoppbereich (SA2) von der leitenden Struktur (23) im optischen Inspektionsbereich (RO) getrennt sind,
wobei die leitenden Strukturen (24) des Rissstoppbereichs (SA) und des weiteren Rissstoppbereichs (SA2) mehrere leitende Elemente (243, 244) auf verschiedenen Ebenen des Stapels (2) umfassen, die auf einer Ebene und von einer Ebene zur anderen voneinander getrennt sind,
und wobei die leitenden Elemente (243, 244) von mindestens zwei benachbarten Ebenen in einer Richtung vom zentralen Bereich (CA) zum Rand (ED) gegeneinander versetzt sind.

10. Verfahren zur Herstellung von Halbleiterchips aus einem Halbleiterwafer nach Anspruch 9, umfassend die folgenden Schritte:
Schneiden des Wafers (1) entlang des Schneidbereichs (CT) in einzelne Halbleiterchips,
optisch Überprüfen zumindest des optischen Inspektionsbereichs (OI) jedes Halbleiterchips auf das Auftreten von Rissen, und
bei Auftreten eines Risses Abtrennen des betreffenden Halbleiterchips.

11. Verfahren nach Anspruch 10,
wobei der Schritt der optischen Inspektion umfasst
- Aufnahme eines Bildes mindestens des optischen Inspektionsbereichs (RO), insbesondere Aufnahme eines Bildes mindestens des optischen Inspektionsbereichs (RO) und des Dichtungsrings (SR),
- Vergleichen des aufgenommene Bildes mit einem Referenzbild, und
- Trennen des betreffenden Halbleiterchips im Falle einer Abweichung des aufgenommenen Bildes vom Referenzbild, die auf das Auftreten eines Risses hinweist.

## Revendications

1. Puce semi-conductrice, comprenant
un substrat (1),
une pile (2) de couches isolantes disposées sur le substrat (1),
dans une zone centrale (CA) de la puce semi-conductrice, au moins un des
- un élément de détection (3), et un circuit (21) dans la pile (2) pour connecter électriquement l'élément de détection (3), et
- des circuits électroniques (11) dans la pile (2),
entre la zone centrale (CA) et un bord (ED) de la puce semi-conductrice :
- un anneau d'étanchéité (SR), et
- une zone d'inspection optique (IO),
dans laquelle les deux, l'anneau d'étanchéité (SR) et la zone d'inspection optique (OI), comprennent des structures conductrices (22, 23) autour de la zone centrale (CA),
dans laquelle la zone d'inspection optique (OI) est disposée entre l'anneau d'étanchéité (SR) et le bord (ED) de la puce semi-conductrice,
dans laquelle chacun des deux éléments, l'anneau d'étanchéité (SR) et la zone d'inspection optique (OI), est prévu dans la pile (2),
dans laquelle l'anneau d'étanchéité (SR) est configurée pour protéger la zone centrale (CA) contre les chocs latéraux, et
dans laquelle la zone d'inspection optique (OI) est configurée pour permettre la détection d'une fissure propagée dans la zone d'inspection optique (OI) par des moyens d'inspection optique,
**caractérisée en ce que** la puce semi-conductrice comprend en outre une zone d'arrêt des fissures (SA) entre la zone d'inspection optique (OI) et le bord (ED) de la puce semi-conductrice,
la zone d'arrêt des fissures (SA) étant prévue dans la pile (2), et
la zone d'arrêt des fissures (SA) étant configurée pour empêcher l'expansion d'une fissure vers la zone centrale (CA) induite par le découpage d'une plaquette de semi-conducteur en plusieurs puces de semi-conducteur,
la zone d'arrêt des fissures (SA) comprenant une structure conductrice (24) pour empêcher l'expansion des fissures,
la structure conductrice (24) dans la zone d'arrêt des fissures (SA) étant déconnectée de la structure conductrice (23) dans la zone d'inspection optique (OI),
la structure conductrice (24) de la zone d'arrêt des fissures (SA) comprenant de multiples éléments conducteurs (243, 244) sur différents niveaux de la pile (2), déconnectés les uns des autres par niveau et à travers les niveaux,
et les éléments conducteurs (243, 244) d'au moins deux niveaux adjacents étant décalés l'un par rapport à l'autre dans une direction allant de la zone centrale (CA) au bord (ED).

2. Puce semi-conductrice selon la revendication 1,
dans laquelle la structure conductrice (22) de l'anneau d'étanchéité (SR) est électriquement déconnectée du circuit (21) dans la zone centrale (CA).

3. Puce semi-conductrice selon la revendication 2,
dans laquelle la structure conductrice (22) de l'anneau d'étanchéité (SR) comprend plusieurs anneaux (221), chacun de ces anneaux (221) étant disposés à un niveau différent dans la pile (2), et
dans laquelle les anneaux (221) des niveaux adjacents sont reliés électriquement par des éléments d'interconnexion (222).

4. Puce semi-conductrice selon l'une des revendications précédentes,
dans laquelle la structure conductrice (23) de la zone d'inspection optique (OI) est électriquement déconnectée de la structure conductrice (22) de l'anneau d'étanchéité (SR).

5. Puce semi-conductrice selon la revendication 4,
dans laquelle la structure conductrice (23) dans la zone d'inspection optique (OI) comprend plusieurs anneaux (231), chacun desdits anneaux (231) étant disposé à un niveau différent dans la pile (2), et
das laquelle les anneaux (231) des niveaux adjacents sont reliés électriquement par des éléments d'interconnexion (232).

6. Puce semi-conductrice selon la revendication 4,
dans laquelle la structure conductrice (23) de la zone d'inspection optique (OI) comprend un anneau unique disposé dans la pile (2).

7. Puce semi-conductrice selon l'une des revendications précédentes, comprenant en outre une couche de passivation (25) appliquée sur le dessus de la puce semi-conductrice et s'étendant sur au moins une partie de ladite zone centrale (CA),
dans laquelle ladite couche de passivation (25) ne s'étend pas sur ladite zone d'arrêt des fissures (SA), et
préférablement dans laquelle ladite couche de passivation (25) ne s'étend pas au-dessus de ladite zone d'inspection optique (OI).

8. Puce semi-conductrice selon l'une des revendications précédentes 3, 5, 6,
dans laquelle la pile (2) comprend des couches métalliques sur différents niveaux entre des couches isolantes correspondantes de la pile (2), à partir desquelles sont réalisés, à partir d'une ou de plusieurs couches métalliques, le circuit (21) dans la zone centrale (CA), la structure conductrice (22) de l'anneau d'étanchéité (SR), la structure conductrice (23) de la zone d'inspection optique (OI), et la structure conductrice (24) de la zone d'arrêt des fissures (SA).

9. Plaquette semi-conductrice pour la fabrication de puces semi-conductrices multiples, comprenant
un substrat de plaquette (1),
une pile (2) de couches isolantes disposées sur le substrat de la plaquette (1),
pour chaque puce semi-conductrice de la plaquette (1), une zone centrale (CA) avec au moins un des éléments suivants
- un élément de détection (3), et un circuit (21) dans la pile (2) reliant l'élément de détection (3), et
- des circuits électroniques (11) dans la pile (2), et
entre chaque deux zones centrales (CA) adjacentes un agencement :
- d'un anneau d'étanchéité (SR1),
- d'une zone d'inspection optique (OI1),
- d'une zone d'arrêt des fissures (SA1),
- d'une zone de découpage (CT),
- d'une autre zone d'arrêt des fissures (SA2),
- d'un autre zone d'inspection optique (OI2), et
- d'un autre anneau d'étanchéité (SR2),
dans laquelle les deux, l'anneau d'étanchéité (SR1) et la zone d'inspection optique (OI1), comprennent des structures conductrices autour de la première correspondante des deux zones centrales adjacentes (CA), et
dans laquelle les deux, l'autre anneau d'étanchéité (SR2) et l'autre zone d'inspection optique (OI2), comprennent des structures conductrices autour de la deuxième correspondante des deux zones centrales adjacentes (CA),
dans laquelle, pour chaque puce semi-conductrice de la plaquette (1)
- la zone d'inspection optique (OI1, OI2) est disposée entre l'anneau d'étanchéité (SR1, SR2) et la zone de découpe (CT),
- chacune des anneaux d'étanchéité (SR1, SR2) et de la zone d'inspection optique (OI1, OI2) est prévue dans la pile (2),
- l'anneau d'étanchéité (SR1, SR2) est configuré de manière à protéger la zone centrale (CA) contre les chocs latéraux, et
- la zone d'inspection optique (OI1, OI2) est configurée pour permettre la détection d'une fissure propagée dans la zone d'inspection optique (OI1, OI2) par des moyens d'inspection optiques,
dans laquelle la zone d'arrêt des fissures (SA) et l'autre zone d'arrêt des fissures (SA2) sont prévues dans la pile (2), et
dans laquelle la zone d'arrêt des fissures (SA) et l'autre zone d'arrêt des fissures (SA2) sont configurées pour empêcher une expansion d'une fissure vers la zone centrale (CA) induite par le découpage d'une plaquette de semi-conducteur en plusieurs puces de semi-conducteur,
dans laquelle la zone d'arrêt des fissures (SA) et l'autre zone d'arrêt des fissures (SA2) comprennent une structure conductrice (24) pour empêcher l'expansion des fissures,
dans laquelle les structures conductrices (24) dans la zone d'arrêt des fissures (SA) et dans l'autre zone d'arrêt des fissures (SA2) sont déconnectées de la structure conductrice (23) dans la zone d'inspection optique (OI),
dans laquelle les structures conductrices (24) de la zone d'arrêt des fissures (SA) et de l'autre zone d'arrêt des fissures (SA2) comprennent de multiples éléments conducteurs (243, 244) sur différents niveaux de la pile (2), déconnectés les uns des autres par niveau et d'un niveau à l'autre,
et dans laquelle les éléments conducteurs (243, 244) d'au moins deux niveaux adjacents sont décalés l'un par rapport à l'autre dans une direction allant de la zone centrale (CA) au bord (ED).

10. Procédé de fabrication de puces de semi-conducteurs à partir d'une plaquette de semi-conducteurs selon la revendication 9, comprenant les étapes suivantes :
découper la plaquette (1) le long de la zone de découpage (CT) en puces semi-conductrices individuelles,
inspecter optiquement au moins la zone d'inspection optique (IO) de chaque puce semi-conductrice pour détecter l'apparition de fissures, et
en cas d'apparition d'une fissure séparer la puce semi-conductrice concernée.

11. Procédé selon la revendication 10,
dans lequel l'étape d'inspection optique comprend
- prendre une image d'au moins la zone d'inspection optique (OI), en particulier prendre une image d'au moins la zone d'inspection optique (OI) et l'anneau d'étanchéité (SR),
- comparer l'image prise avec une image de référence, et
- séparer la puce semi-conductrice concernée en cas de déviation de l'image prise par rapport à l'image de référence indiquant l'apparition d'une fissure.
